# EUROPEAN PATENT APPLICATION

(11) **EP 4 568 113 A1**
(43) Date of publication of application: **11.06.2025**
(21) Application number: 24157935.8
(22) Date of filing: 15.02.2024
(51) Int. Cl.: H03M 1/06, H03M 1/10, H03M 1/16

(54) **CONTINUOUS-TIME PIPELINE ADC AND METHOD FOR A DELAY MATCHING TECHNIQUE IN A CONTINUOUS-TIME PIPELINE ADC**

(30) Priority: 06.12.2023 IN 202341082981
(71) Applicant: NXP B.V., 5656 AG Eindhoven (NL)
(72) Inventor: Singh, Kamlesh, 5656AG Eindhoven (NL); Gupta, Sushil Kumar, 5656AG Eindhoven (NL); Panpalia, Ashish Ashok, 5656AG Eindhoven (NL); Agrawal, Pankaj, 5656AG Eindhoven (NL)
(74) Representative: Krott, Michel

(57) **Abstract**

A continuous-time analog-to-digital converter circuit (100), comprising:
- an input (1) to which an analog input signal (vᵢₙ) can be applied;
- an analog delay element (10a... 10n) being interconnected between the input (1) and a first summation node (20);
- an ADC-DAC path interconnected between the input (1) and the first summation node (20), the ADC-DAC path being operative to digitize the analog input signal (vᵢₙ) and to reconvert the digitized analog input signal back to analog and to subtract the reconverted signal at the first summation node (20), the ADC-DAC path comprising:
- a switch (S1) interconnected between the input (1) and a sub ADC (11), the switch being operative to sample the analog input (vin) with a specified sampling rate (fs);
- a sub DAC (12a... 12n) interconnected between the sub ADC (11) and the first summation node (20), wherein delays of the analog delay element (10a... 10n) and the ADC-DAC path are matched by means of a delay control element (50), wherein an output (r) at the first summation node (20) is filtered by a filter element (30), wherein an output of the filter element (30) is sampled by the specified sampling rate (fs); and
- a backend ADC (41) connected to a second summation node (43) and being operative to digitize the sampled output of the filter element (30); wherein the ADC-DAC path is operative to match its delay to the delay (td) of the analog delay element (10a... 10n).

## Description

### TECHNICAL FIELD

The present disclosure relates to a continuous-time pipeline ADC circuit. Furthermore, the present disclosure relates to a method for performing a delay matching technique in a continuous-time pipeline ADC circuit.

### BACKGROUND

In continuous-time pipeline ADCs (CTP ADCs), a residue is generated by subtracting a digitized version of the analog input signal from the continuous-time signal. The delay between the two paths need to be matched. Usually, the delay of ADC-DAC path would be > 0.5Tₛ (for a zero order hold DAC) but less than 1.5Tₛ, where Tₛ is one clock period of a sampling frequency.

US 11,133,814 B1 discloses continuous-time residue generation analog-to-digital converter arrangements with programmable analog delay.

US 10,651,870 B2 discloses input path matching in pipelined continuous-time analog-to-digital converters.

US 11,563,442 B2 disclose calibration of continuous-time residue generation systems for analog-to-digital converters.

### SUMMARY

It is an object of the present invention to provide an improved continuous-time analog-to-digital converter circuit.

According to a first aspect, the present disclosure proposes an continuous-time analog-to-digital converter circuit, comprising:
- an input to which an analog input signal can be applied;
- an analog delay element being interconnected between the input and a first summation node;
- an ADC-DAC path interconnected between the input and the first summation node, the ADC-DAC path being operative to digitize the analog input signal and to reconvert the digitized analog input signal back to analog and to subtract the reconverted signal at the first summation node, the ADC-DAC path comprising:
- a switch interconnected between the input and a sub-ADC, the switch being operative to sample the analog input with a specified sampling rate;
- a sub-DAC interconnected between the sub-ADC and the first summation node, wherein delays of the analog delay element and the ADC-DAC path are matched by means of the delay control device, wherein an output at the first summation node is filtered by a filter element, wherein an output of the filter element is sampled by the specified sampling rate; and
- a backend ADC connected to a second summation node and being operative to digitize the sampled output of the filter element; wherein the ADC-DAC path is operative to match its delay to the delay of the analog delay element.

In this way, a delay of the analog path can be closely matched to the delay of the ADC-DAC path of the CTP ADC. As a result, no switches are necessary in the analog path to match delays. The better matching of the delays allows an increased gain of an analog filter block, which means that more bits per stages can be extracted from the digitized signal. The proposed CTP ADC is e.g. usable for high bandwidth ADCs with a medium resolution of e.g. 10 to 14 bits. The proposed CTP ADC circuit is able to provide a wider tuning of delay mismatch to account for variations in analog signal delay path, e.g. due to PVT-conditions.

According to a further aspect, the present disclosure proposes a method for calibrating a CTP ADC device, comprising the steps:
- applying an analog input signal to an input;
- digitizing the analog input signal and reconverting the digitized analog input signal back to analog and subtract the reconverted signal at a first summation node;
- sampling the analog input with a specified sampling rate;
- filtering an output at the first summation node by a filter element and sampling of an output of the filter element by the specified sampling rate;
- digitizing the sampled output of the filter element; and
- matching the delay of a ADC-DAC path of the continuous-time analog-to-digital converter circuit to the delay of the analog delay element.

In one or more embodiments, the delay of the ADC-DAC path is controlled by means of a coarse delay control and a fine delay control.

In one or more embodiments, the coarse delay control comprises elements to be switched in a connection path between the sub-ADC and the sub-DAC and wherein the fine delay control is configured to control a clock signal of the sub-DAC.

According to one or more embodiments, the coarse delay control comprises delay elements which are enabled in dependency of a variance of an output signal of the backend ADC.

According to one or more embodiments, the coarse delay control and the fine delay control are controlled by a control device, the control device being operative to perform the delay matching in two steps, wherein in a first step the coarse delay is configured to be as close as possible to the delay of the analog delay element.

According to one or more embodiments, wherein, once the coarse delay is set, the fine delay is set.

According to one or more embodiments, the control device is operative to work in dependency of a variance of an output signal of the backend ADC.

According to one or more embodiments, the fine delay control is implemented by means of a delay control logic of the control device.

According to one or more embodiments, a value of the sampling rate of the output of the continuous-time analog filter is equal or smaller than a value of the sampling rate of the sub DACs.

### BRIEF DESCRIPTION OF DRAWINGS

The above discussion/summary is not intended to describe each embodiment or every implementation of the present disclosure. The drawings and detailed description that follow also exemplify various embodiments. The aspects defined above and further aspects of the present disclosure are apparent from the examples of embodiment to be described hereinafter with reference to the appended drawings, which are explained with reference to the examples of embodiment. Needless to say, that the disclosure is not limited to the examples of embodiments.

All illustrations in the drawings are schematical. It is noted that in different figures, similar or identical elements or features are provided with the same reference signs or with reference signs that are different from the corresponding reference signs only within the first digit. In order to avoid unnecessary repetitions, elements or features which have already been elucidated with respect to a previously described embodiment are not elucidated again at a later position of the description.

Various example embodiments may be more completely understood in consideration of the following detailed description in connection with the accompanying drawings, in which:
- FIG. 1: shows a block diagram of a conventional continuous-time pipeline ADC circuit;
- FIG. 2: shows a block diagram of an embodiment of a proposed continuous-time pipeline ADC circuit;
- FIG. 3: are diagrams showing a performance of the proposed continuous-time pipeline ADC circuit;
- FIG. 4: is a diagram with signals of the proposed continuous-time pipeline ADC circuit;
- FIG. 5: is a diagram showing a performance of a proposed continuous-time pipeline ADC circuit;
- FIGs. 6, 7: are diagrams showing variation of SNDR with frequency and input signal amplitude, respectively;
- FIGs. 8, 9: are block diagrams of a further embodiment of the of a proposed continuous-time pipeline ADC circuit;
- FIGs. 10, 11: are diagrams showing a context between a variance of the backend ADC and a swing at the second pipeline stage;
- FIG. 12: is a diagram showing a performance of a proposed continuous-time pipeline ADC circuit;
- FIG. 13: is a diagram showing an iteration procedure; and
- FIG. 14: shows a flow of the proposed method.

While various embodiments discussed herein are amenable to modifications and alternative forms, aspects thereof have been shown by way of example in the drawings and will be described in detail. It should be understood, however, that the intention is not to limit the disclosure to the particular embodiments described. On the contrary, the intention is to cover all modifications, equivalents, and alternatives falling within the scope of the disclosure including aspects defined in the claims. In addition, the term "example" as used throughout this application is only by way of illustration, and not limitation.

### DESCRIPTION OF EMBODIMENTS

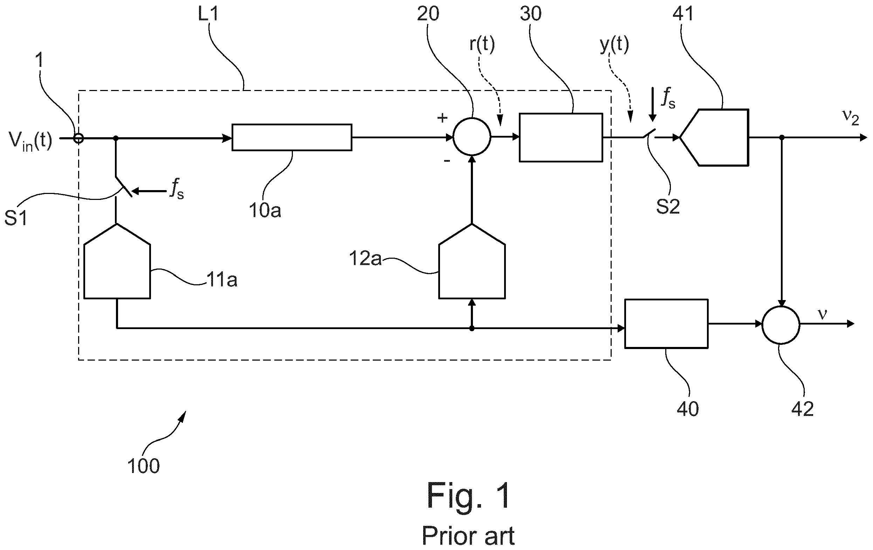

FIG. 1 shows a block diagram of a conventional continuous timeline analog-to-digital converter circuit 100. One recognizes an input 1, to which an analog input signal vin(t) can be applied. An analog delay element 10a is connected to the input 1 having a specific time delay t_{d} and is further connected to a first summation node 20. An ADC-DAC path is interconnected between the input 1 and the first summation node 20 comprising a switch S1, being switched with a specific rate fₛ, a sub-ADC 1 1a being connected to the switch S1 and the sub-DAC 12a being connected to the sub-ADC 11a and to the first summation node 20. In this way, a digitization and reconversion of the digitized analog input signal vᵢₙ(t) into analog is performed and the reconverted digital is subtracted at the first summation node 20. An output of the first summation node 20 is a residue r(t), which is fed to a first analog filter 30 (continuous time filter G(s)). An output of the first analog filter 30 is sampled by means of a switch S2 with the specific rate fs and is applied to a backend ADC 41, which is connected to a second summation node 42. Furthermore, the output of the sub-ADC 11a is also connected to a digital filter 40, whose output is connected to the second summation node 42. An output of the second summation node 42 represents a final signal v of the CTP ADC circuit 100.

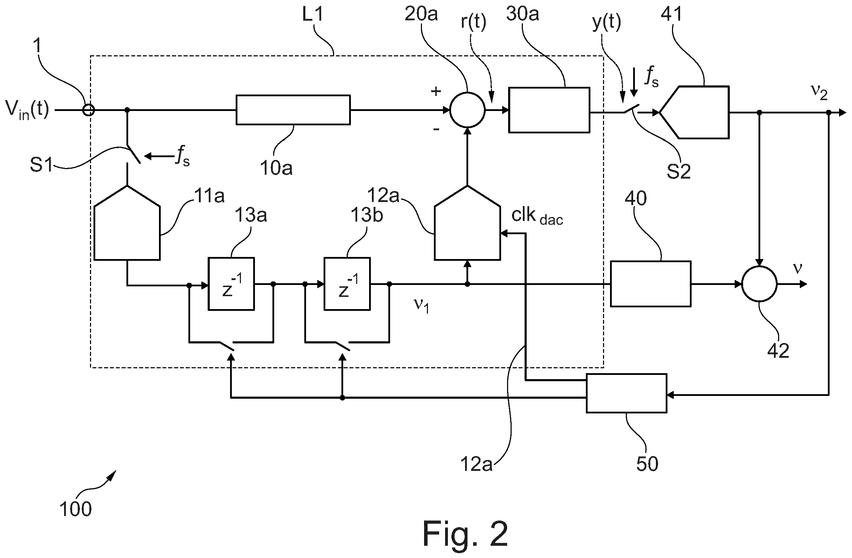

FIG. 2 shows a block diagram of an embodiment of a proposed continuous-time ADC 100. Identical to the conventional arrangement of FIG. 1, the analog input signal vin(t) is digitized using the sub-ADC 11a and is reconstructed by means of the sub-DAC 12a. The reconstructed signal is then subtracted from the delayed vᵢₙ(t) at the first summation node 20a in order to generate the residue r(t). The residue r(t) is then filtered and amplified using the continuous-time filter 30a. An output y(t) of the filter 30a is sampled and digitized to v₂ using the backend ADC 41. The sampling of backend-ADC 41 can be skewed to allow for settling of the filter. The final CTP ADC output v is obtained by combining v1 via a digital filter 40 with the backend ADC output v₂.

It is proposed to match the delay t_{d} of the analog delay element 10a to the delay of the ADC-DAC path in order to minimize the residue r(t) at the first summation node 20a. The better said delay matching, the smaller the residue r(t), which allows to use a larger gain in the continuous-time filter 30a, which relaxes requirements of the back-end ADC 41. To this end, the signal path delay t_{d} is set to a maximum possible delay of the sub-ADC-sub-DAC path without considering delay elements 13a, 13b shown in FIG. 2, accounting for PVT (Process-Voltage-Temperature)/mismatch variations with some additional margin.

The delay matching of the analog path with the analog delay element 10a and the ADC-DAC path is achieved by tuning the delay of sub-ADC-sub-DAC path. With an ideal sub-ADC 11a and sub-DAC 12a (zero order hold), the sub-ADC-sub-DAC path will have a delay of e.g. 0.5Tₛ. By delaying sub-DAC clock clk_{dac}, a maximum additional delay of e.g. Tₛ can be added in the sub-ADC1-sub-DAC path.

For example, if the delay t_{d} of the analog delay element 10a is Tₛ, then the delay control element 50 can skew the clock signal clk_{dac} of the sub-DAC 12a by additional ~ 0.5Tₛ. However, if the delay t_{d} of the analog delay element 10a spreads to > 1.5Tₛ or 1.6Tₛ, then the adjustment of the clock signal clk_{dac} cannot make the delay of the mentioned two paths equal.

In that case, one of the delay elements 13a, 13b (e.g. implemented as Flip-Flops) is enabled to add additional Tₛ delay and then the clock signal clk_{dac} can be adjusted to provide remaining 0.1Tₛ delay. The z⁻¹ taps of the delay elements 13a, 13b provide a coarse control of the delay, while the delay of the clock signal clk_{dac} allows finer adjustment of the delay matching process. Together, they can cover a wide spread in the delay t_{d} of the analog delay element 10a. Thus, no programmability/delay tuning is required in the analog delay element 10a.

The delay control device 50 works to find the delay of the clock signal clk_{dac} between 0 and Tₛ, such that a variance of the output v2 of the back-end ADC 41 may be minimized. This works because aim of the proposed delay matching is to minimize a swing of the residue r(t) and hence the output y(t) of the analog filter 30a. This information is contained in digitized form in the output v₂ of the back-end ADC 41. The calibration of the delay should preferably be done with input frequency at edge of the signal band, however, any different shape of waveform can also be used, like e.g. sawtooth. In the following, an example of the delay tuning process is given for t_{d} = *2***Tₛ* for a reference voltage vref = 1V. First, the variance of the output v₂ of the backend ADC 41 is determined for each of coarse delay configuration for a nominal value of clk_{dac} delay. The coarse delay control is optional, if t_{d} < Tₛ. The following table:

| Delay | var (v2) |
|---|---|
| no delay | 0.6907 |
| 1 tap (z⁻¹) | 0.2124 |
| 2 tap (z⁻²) | 0.3834 |

shows, that based on the minimum variance of v₂, a 1-tap delay is set for the coarse control of the delay matching process, i.e. the delay element 13a is enabled via the delay control device 50 via a corresponding switch.

A value of the sampling rate fₛ of the output of the continuous-time analog filter 30 is equal to a value of the sampling rate fₛ of the sub DACs 11, 12. In an alternative, the value of the sampling rate fₛ of the output of the continuous-time analog filter 30 can also be smaller than a value of the sampling rate of the sub DACs 11, 12. As a result, this means that a value of the sampling rate fₛ of the backend ADC 41 can be same or smaller than the sampling rate of the sub DACs 11, 12.

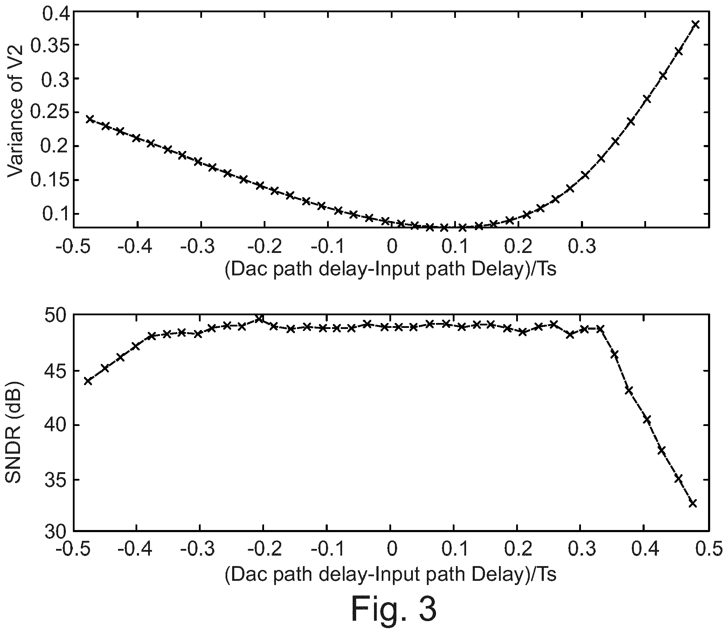

FIG. 3 shows in two diagrams that once the above illustrated coarse delay is set, the delay control device 50 may find an optimum value of the clock signal clk_{dac} of the sub-DAC 12a delay between 0 and Tₛ which can further minimize the variance of the output v₂ of the backend ADC 41, which is used as an input for the delay control device 50. This could be based e.g. on a LMS-algorithm or any other search algorithm, which may be implemented as a delay control logic within the delay control device 50.

The upper diagram of FIG. 3 shows the variance of the output signal v2 of the backend ADC 41 as the fine delay is varied by means of the signal clk_{dac}, wherein a minimum is reached. At the point, where the variance gets minimized, the delay of the two paths, i.e. the analog path with the analog delay element 10a and the ADC-DAC path with the sub-ADC 11a and the sub-DAC 12a are matched. In other words, once the delay of the variance of the output v2 of the backend ADC 41 is minimized, the delays of the two paths are also matched. One recognizes the behaviour of var(v₂) with respect to the clock signal clk_{dac}, which confirms that the calibration algorithm converges to the minimum value. For example, the calibration algorithm may converge to a region between appr. 0 and appr. 0.1.

The lower diagram of FIG. 3 shows a performance of the proposed CTP ADC circuit 100 in terms of S/N-ratio (SNDR), wherein a context with the upper diagram shows a certain margin, wherein even when the performance varies within this margin, there is not a lot of degradation in terms of SNDR, in the present case between appr. -0.2 and appr. 0.3.

Advantageously, within this margin a recalibration of the CTP ADC circuit 100 is not necessary. Corresponding calibration data can be stored in a memory (not shown) for a subsequent use. The diagram shows the variation of SNDR with respect to delay mismatch between the analog path and the ADC-DAC path. One recognizes, that as the mismatch between the delay of the two paths reduces, a certain SNDR performance is obtained, wherein, when the matching is poor, then a degradation starts.

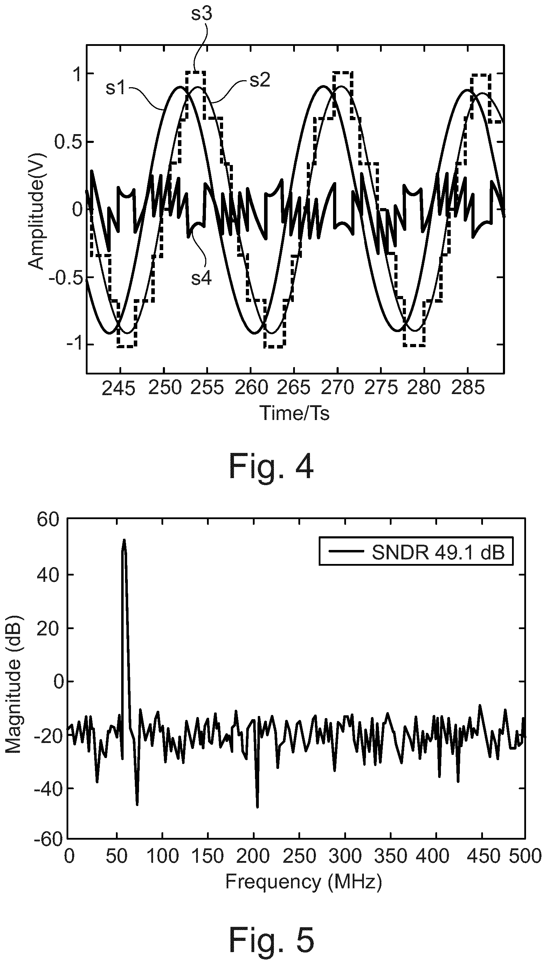

FIG. 4 shows a plot with respect to time of the following signals used in the proposed CTP ADC circuit 100: analog input signal s1 (vin(t)), delayed analog input signal s2(t), output signal s3(t) of the sub-DAC 12a and residue signal s4 (r(t)).

FIG. 5 shows the output spectrum of the proposed CTP ADC circuit 100 with a 2.5 bit pipeline stage and a 6 bit backend ADC 41. The SNDR obtained is 49.1 dB, whereas the analog input signal vᵢₙ(t) being applied at the input 1 of the CTP ADC circuit 100, which confirms that the proposed CTP ADC circuit 100 works as expected.

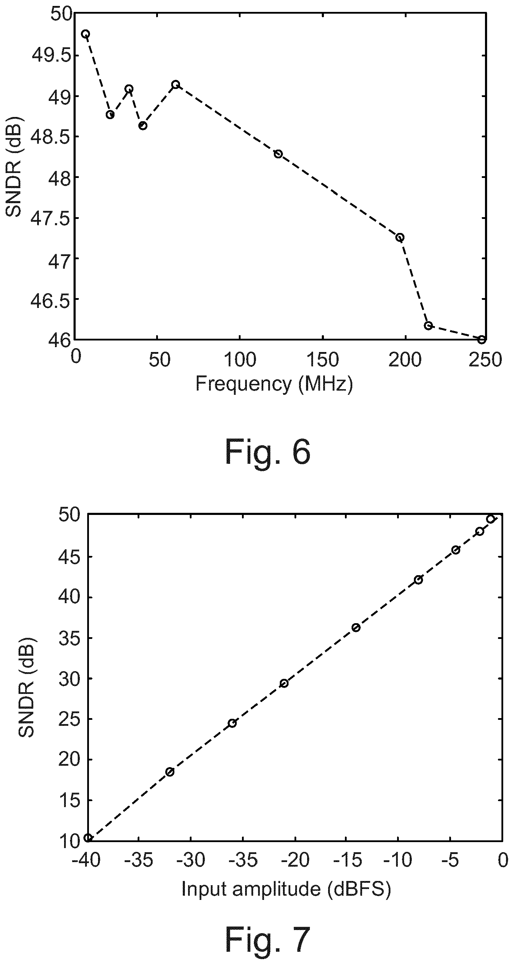

FIG. 6 shows the variation of SNDR with frequency after delay tuning at 60 MHz input. The analog filter 30a has 3-dB bandwidth of 250 MHz.

FIG. 7 shows the variation of SNDR with input amplitude for a 60 MHz input signal.

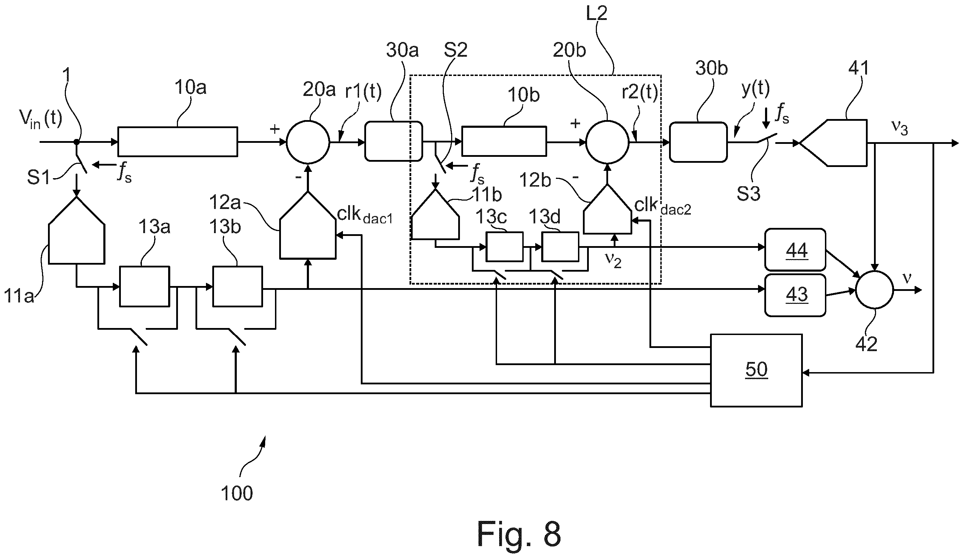

FIG. 8 shows an extension of the proposed CTP ADC circuit 100 to two pipeline stages. A simple DC-blocker (not shown) can also be used to get rid of DC-component from the signals v2 or v3 (inputs to the digital-algorithmic-tuning block). The DC-blocker helps to simplify the mathematical operation on v2/v3 which could simply be average of absolute than variance. Delay tuning time would depend on the mathematical operation and digital algorithm working on v2/v3.

The above illustrated calibration procedure has to be performed for the two pipeline stages L1, L2 of the proposed CTP ADC circuit 100. Firstly, e.g. the delay tuning of the last pipeline stage L2 may be done, in a manner similar to the single pipeline stage arrangement described above with respect FIG. 2. First, the second pipeline stage (innermost loop) L2 is calibrated and the output v3 of the backend ADC 41 is used.

A test input signal Vᵢₙ(t) is applied at the input 1. To ensure, that the delay mismatch of the first pipeline stage L1 does not interfere with the result, the sub-ADC 11a and the sub-DAC 12a of the ADC-DAC-path of the first pipeline stage L1 are disabled. Coarse and fine delays are adjusted to minimize the variance of the output signal v3 of the back-end ADC 41.

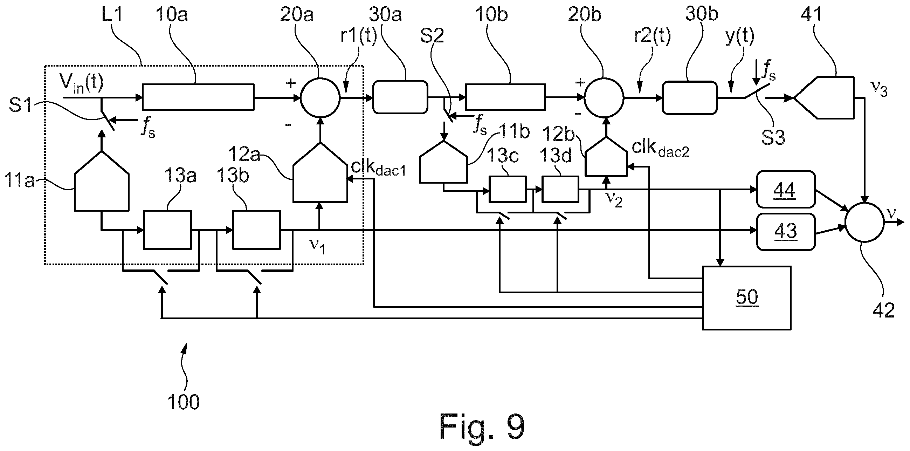

Afterwards, when the delays of the second pipeline stage L2 have been matched, the delay of the ADC-DAC path of the first pipeline stage L1 is tuned, as shown in FIG. 9. After applying the test input vᵢₙ(t) , the coarse and fine delays are adjusted to minimize the variance of the second pipeline stage sub-ADC output v2. The output v3 of the back-end ADC 41 is not used. The reason is that a swing at the output v3 has very less sensitivity to delay mismatch of the first pipeline stage L1. While delay mismatch of the first pipeline stage L1 increases swing at r1(t), it does not result in proportional swing increase at v3, due to already matched delay of the second pipeline stage L2. Optionally, even the output v3 of the backend ADC 41 can be used, however with increased amount of time to tune the delay mismatch.

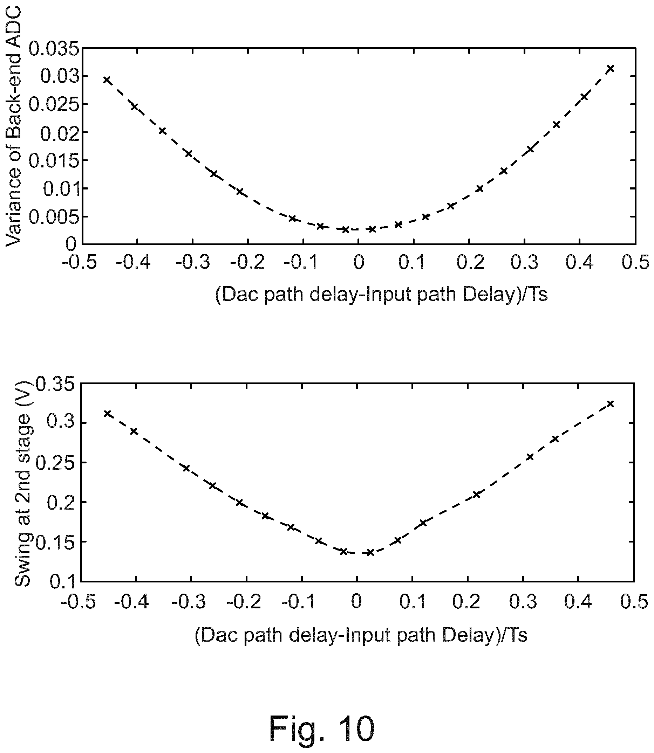

FIG. 10 shows the variation of the back-end ADC variance as the delay of the second pipeline stage L2 of the arrangement of FIG. 8 is varied. One recognizes, that a minimum variance is achieved when the delay matches. Global minima shows that convergence to minimum delay can be achieved. As expected and shown in a lower drawing of FIG. 10, a swing at the output of the second pipeline stage L2 is also minimized when the delay matches.

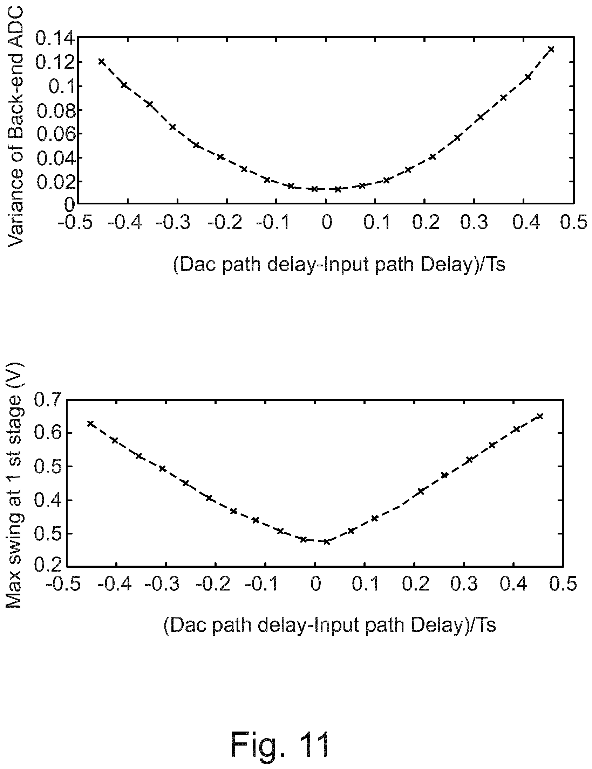

FIG. 11 shows that after the second pipeline stage delay is tuned, the first pipeline stage tuning is done. An upper drawing shows a variance of the second pipeline stage sub-ADC 11b when the delay mismatch in the first pipeline stage L1 is varied. A minimum variance is achieved when delay matches. A global minima shows that convergence to minimum delay can be achieved. As expected and shown in a lower drawing of FIG. 11, a swing at the output of the second pipeline stage L2 is also minimized when the delay matches. Once both stages L1, L2 have been calibrated, the CTP ADC circuit 100 works in normal mode by adding output signals v1, v2 of the two stages L1, L2, which are filtered by means of digital filters 43, 44 and summed at the second summation node 42 with the output signal v3 of the backend ADC 41, thus resulting in a final output signal v of the CTP ADC circuit 100. The above illustrated calibration principle may be performed with additional stages (not shown) of the CTP ADC circuit 100.

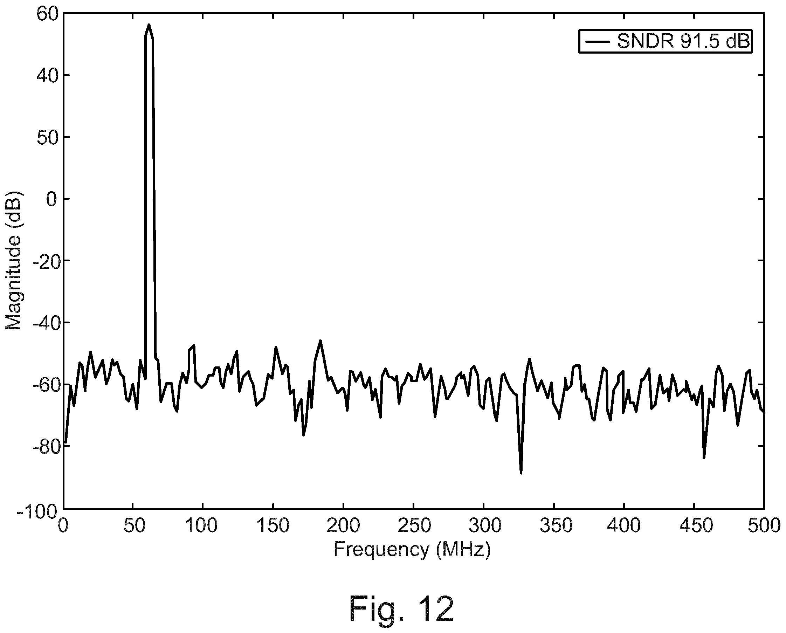

FIG. 12 shows a diagram similar to FIG. 5 with SNDR after matching of delays. It shows the output spectrum of the ADC with SNDR of 91.5 dB, which shows that the proposed CTP ADC circuit 100 works.

A relation between variance and delay mismatch shows a global minima. Besides, the relation is convex wherein derivative is monotonically non-decreasing. This enables an optimization algorithm like e.g. the Nelder-Mead Simplex Algorithm, which is a preferred choice for the proposed implementation.

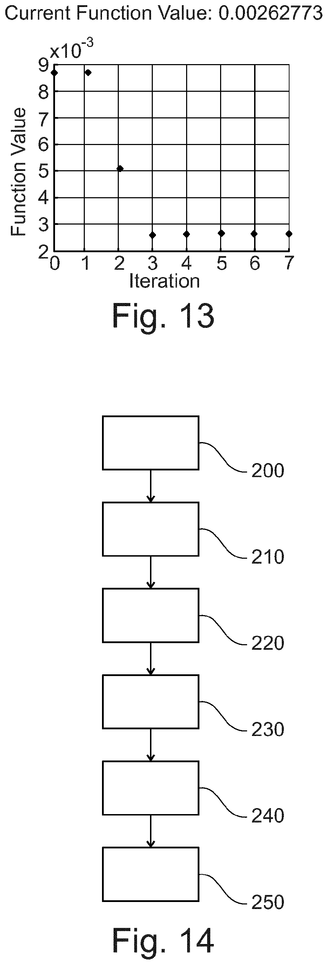

FIG. 13 shows that a convergence within less than ten iterations where 5K samples were taken for each iteration to calculate the variance of the backend ADC, wherein said algorithm are implemented in the delay control device 50. It can be seen that after three iterations the matching is done and more iterations do not result in any advantageous effects.

FIG. 14 shows a principal method flow of the proposed method.

In a step 200 an analog input signal vᵢₙ is applied to an input 1.

In a step 210 digitizing of the analog input signal vᵢₙ and reconverting the digitized analog input signal back to analog and subtract the reconverted signal at a first summation node 20 is performed.

In a step 220 a sampling the analog input vin with a specified sampling rate fs is performed.

In a step 230 a filtering an output at the first summation node 20 by a filter element 30 and a sampling of an output of the filter element 30 by the specified sampling rate fs is done.

In a step 240 the sampled output of the filter element 30 is digitized.

In a step 250 a matching the delay of an ADC-DAC path of the continuous-time analog-to-digital converter circuit 100 to the delay t_{d} of the analog delay element 10a... 10n is performed.

Proposed is a delay matching technique in CTP by adjusting the delay in the ADC-DAC path and not in the analog signal path. Delay mismatch of more than one clock cycle can be tuned by using a combination of coarse and fine delay adjustment. In effect, a digital calibration circuit is provided that works in two steps, wherein a first setting handles a coarse calibration followed by a finer sub-DAC clock delay adjustment.

All mentioned numerical values are only exemplary and can be exchanged with alternative suitable numerical values. Also, the disclosed numerical values are to be understood in a qualitative sense and are represented in a standardized form.

The proposed CTP ADC circuit 100 can be used for applications requiring high speed analog-to-digital converters. The proposed architecture also has anti-aliasing properties, which can help remove anti-aliasing filter or greatly relax its design.

In the foregoing description various specific details have been set forth to describe specific examples presented herein. It should be apparent to one skilled in the art, however, that one or more other examples and/or variations of these examples may be practiced without all the specific details given below. In other instances, well known features have not been described in detail so as not to obscure the description of the examples herein. For ease of illustration, the same reference signs may be used in different diagrams to refer to the same elements or additional instances of the same element. Also, although aspects and features may in some cases be described in individual figures, it will be appreciated that features from one figure or embodiment can be combined with features of another figure or embodiment even though the combination is not explicitly shown or explicitly described as a combination.

As examples, the specification describes and/or illustrates aspects useful for implementing the claimed disclosure by way of various circuits or circuitry which may be illustrated as or using terms such as blocks, modules, device, system, unit, controller, etc. and/or other circuit-type depictions. Such circuits or circuitry are used together with other elements to exemplify how certain embodiments may be carried out in the form or structures, steps, functions, operations, activities, etc. As examples, wherein such circuits or circuitry may correspond to logic circuitry (which may refer to or include a code-programmed/configured CPU, in one example the logic circuitry may carry out a process or method (sometimes "algorithm") by performing such activities and/or steps associated with the above-discussed functionalities. In other examples, the logic circuitry may carry out a process or method by performing these same activities/operations.

For example, in certain of the above-discussed embodiments, one or more modules are discrete logic circuits or programmable logic circuits configured and arranged for implementing these operations/activities. In certain embodiments, such a programmable circuit is one or more computer circuits, including memory circuitry for storing and accessing a program to be executed as a set (or sets) of instructions (and/or to be used as configuration data to define how the programmable circuit is to perform), and an algorithm or process as described above is used by the programmable circuit to perform the related steps, functions, operations, activities, etc. Depending on the application, the instructions (and/or configuration data) can be configured for implementation in logic circuitry, with the instructions (whether characterized in the form of object code, firmware or software) stored in and accessible from a memory (circuit). As another example, where the specification may make reference to a "first" type of structure, a "second" type of structure, where the adjectives "first" and "second" are not used to connote any description of the structure or to provide any substantive meaning; rather, such adjectives are merely used for English-language antecedence to differentiate one such similarly-named structure from another similarly-named structure.

Based upon the above discussion and illustrations, those skilled in the art will readily recognize, that various modifications and changes may be made to the various embodiments without strictly following the exemplary embodiments and applications illustrated and described herein. For example, methods as exemplified in the Figures may involve steps carried out in various orders, with one or more aspects of the embodiments herein retained, or may involve fewer or more steps.

It should be noted that the term "comprising" does not exclude other elements or steps and "a" or "an" does not exclude a plurality. Also elements described in association with different embodiments may be combined. It should also be noted, that reference signs in the claims should not be construed as limiting the scope of the claims.

The discloses devices, apparatuses, units, elements, systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer readable medium, which may include storage devices and signals, in compressed or uncompressed form.

It is noted that the embodiments above have been described with reference to different subject-matters. In particular, some embodiments may have been described with reference to method-type claims whereas other embodiments may have been described with reference to apparatus-type claims.

However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

It has to be noted that embodiments have been described with reference to different subject matters. In particular, some embodiments have been described with reference to method type claims whereas other embodiments have been described with reference to apparatus type claims.

However, a person skilled in the art will gather from the above description that, unless other notified, in addition to any combination of features belonging to one type of subject matter also any combination between features relating to different subject matters, in particular between features of the method type claims and features of the apparatus type claims is considered as to be disclosed with this application.

### Reference signs:

- 1: input
- 10a... 10n: analog delay element
- 11a... 11n: sub-ADC
- 12a...12n: sub-DAC
- 13a... 13d: delay element
- 20a, 20b: first summation node
- 30a, 30b: analog filter
- 43, 44: digital filter
- 41: backend ADC
- 42: second summation node
- 50: delay control device
- 100: CTP ADC circuit
- 200... 250: method steps
- fₛ: sampling rate
- L1... Ln: pipeline stages
- s1(t): input signal
- s2(t): delayed input signal
- s3(t): output signal of sub-DAC
- s4(t): residue r(t)
- 51... S3: switches
- t_{d}: time delay

## Claims

1. A continuous-time analog-to-digital converter circuit (100), comprising:
- an input (1) to which an analog input signal (vᵢₙ) can be applied;
- an analog delay element (10a... 10n) being interconnected between the input (1) and a first summation node (20);
- an ADC-DAC path interconnected between the input (1) and the first summation node (20), the ADC-DAC path being operative to digitize the analog input signal (vᵢₙ) and to reconvert the digitized analog input signal back to analog and to subtract the reconverted signal at the first summation node (20), the ADC-DAC path comprising:
- a switch (S1) interconnected between the input (1) and a sub ADC (11), the switch being operative to sample the analog input (vin) with a specified sampling rate (fs);
- a sub DAC (12a... 12n) interconnected between the sub ADC (11) and the first summation node (20), wherein delays of the analog delay element (10a... 10n) and the ADC-DAC path are matched by means of a delay control element (50), wherein an output (r) at the first summation node (20) is filtered by a filter element (30), wherein an output of the filter element (30) is sampled by the specified sampling rate (fs); and
- a backend ADC (41) connected to a second summation node (43) and being operative to digitize the sampled output of the filter element (30); wherein the ADC-DAC path is operative to match its delay to the delay (td) of the analog delay element (10a... 10n).

2. The continuous-time analog-to-digital converter circuit (100) according to claim 1, wherein the delay of the ADC-DAC path is controlled by means of a coarse delay control and a fine delay control.

3. The continuous-time analog-to-digital converter circuit (100) according to claim 2, wherein the coarse delay control comprises elements (13a, 13b) to be switched in a connection path between the sub ADC (11) and the sub DAC (12) and wherein the fine delay control is configured to control a clock signal of the sub DAC (12).

4. The continuous-time analog-to-digital converter circuit (100) according to claim 3, wherein the coarse delay control comprises delay elements (13a, 13b) which are enabled in dependency of a variance of an output signal (v2) of the backend ADC (41).

5. The continuous-time analog-to-digital converter circuit (100) according to any of claims 2 to 4, wherein the coarse delay control and the fine delay control is controlled by the delay control device (50), the delay control device (50) being operative to perform the delay matching in two steps, wherein in a first step the coarse delay is configured to be as close as possible to the delay (t_{d}) of the analog delay element (10a... 10n).

6. The continuous-time analog-to-digital converter circuit (100) according to claim 5, wherein once the coarse delay is set, the fine delay is set.

7. The continuous-time analog-to-digital converter circuit (100) according to claim 4 or 5, wherein the delay control device (50) is operative to work in dependency of a variance of an output signal of the backend ADC (41).

8. The continuous-time analog-to-digital converter circuit (100) according to any of the preceding claims, wherein the fine delay control is implemented by means of a delay control logic of the delay control device (50).

9. The continuous-time analog-to-digital converter circuit (100) according to any of the preceding claims, wherein a value of the sampling rate (fs) of the output y(t) of the continuous-time analog filter (30) is equal or smaller than a value of the sampling rate (fs) of the sub DACs (11a, 12a).

10. ADC device comprising at least one continuous-time analog-to-digital converter circuit (100) according to the preceding claims.

11. ADC device according to claim 10, wherein the delays of the circuits (100) are calibrated sequentially in a specified order, wherein the outputs of each single circuit (100) are used.

12. Method for calibrating a continuous-time analog-to-digital converter circuit (100), comprising the steps:
- applying an analog input signal (vᵢₙ) to an input (1);
- digitizing the analog input signal (vᵢₙ) and reconverting the digitized analog input signal back to analog and subtract the reconverted signal at a first summation node (20);
- sampling the analog input (vin) with a specified sampling rate (fs);
- filtering an output (r) at the first summation node (20) by a filter element (30) and sampling of an output of the filter element (30) by the specified sampling rate (fs);
- digitizing the sampled output of the filter element (30); and
- matching the delay of an ADC-DAC path of the continuous-time analog-to-digital converter circuit (100) to the delay (td) of the analog delay element (10a... 10n).

13. Method according to claim 12, wherein at first the coarse delay is set to come as close as possible to the delay of the analog delay element (10a... 10n).

14. Method according to claim 12, wherein once the coarse delay is determined, a fine tuning is done by controlling a clock signal of a sub-DAC of the ADC-DAC path.

15. Method according to any of the claims 12 to 14, wherein data with respect to the matching procedure are stored.

## Amended claims

### Amended claims in accordance with Rule 137(2) EPC.

1. A continuous-time analog-to-digital converter circuit (100), comprising:
- an input (1) to which an analog input signal (vᵢₙ) can be applied;
- an analog delay element (10a... 10n) being interconnected between the input (1) and a first summation node (20a; 20b);
- an ADC-DAC path interconnected between the input (1) and the first summation node (20a; 20b), the ADC-DAC path being operative to digitize the analog input signal (vᵢₙ) and to reconvert the digitized analog input signal back to analog and to subtract the reconverted signal at the first summation node (20a; 20b), the ADC-DAC path comprising:
- a switch (S1) interconnected between the input (1) and a sub ADC (11a...11n), the switch (S1) being operative to sample the analog input (vin) with a specified sampling rate (fs);
- a sub DAC (12a...12n) interconnected between the sub ADC (11a...11n) and the first summation node (20a; 20b), wherein delays of the analog delay element (10a...10n) and the ADC-DAC path are matched by means of a delay control element (50), wherein an output (r) at the first summation node (20a; 20b) is filtered by an analog filter element (30a; 30b), wherein an output of the analog filter element (30a; 30b) is sampled by the specified sampling rate (fs); and
- a backend ADC (41) connected to a second summation node (42) and being operative to digitize the sampled output of the analog filter element (30a; 30b); wherein the ADC-DAC path is operative to match its delay to the delay (td) of the analog delay element (10a...10n),wherein the delay of the ADC-DAC path is controlled by means of a coarse delay control and a fine delay control, andwherein the coarse delay control comprises delay elements (13a, 13b) to be switched in a connection path between the sub ADC (11a...11n) and the sub DAC (12a...12n) and wherein the fine delay control is configured to control a clock signal (clk_{dac}) of the sub DAC (12a...12n).

2. The continuous-time analog-to-digital converter circuit (100) according to claim 1, wherein the delay elements (13a, 13b) are enabled in dependency of a variance of an output signal (v2) of the backend ADC (41).

3. The continuous-time analog-to-digital converter circuit (100) according to claim 1 or 2, wherein the coarse delay control and the fine delay control is controlled by the delay control device (50), the delay control device (50) being operative to perform the delay matching in two steps, wherein in a first step the coarse delay is configured to be as close as possible to the delay (t_{d}) of the analog delay element (10a...10n).

4. The continuous-time analog-to-digital converter circuit (100) according to claim 3, wherein once the coarse delay is set, the fine delay is set.

5. The continuous-time analog-to-digital converter circuit (100) according to claim 2 or 3, wherein the delay control device (50) is operative to work in dependency of a variance of an output signal of the backend ADC (41).

6. The continuous-time analog-to-digital converter circuit (100) according to any of the preceding claims, wherein the fine delay control is implemented by means of a delay control logic of the delay control device (50).

7. The continuous-time analog-to-digital converter circuit (100) according to any of the preceding claims, wherein a value of the sampling rate (fs) of the output y(t) of the analog filter element (30a; 30b) is equal or smaller than a value of the sampling rate (fs) of the sub ADCs (11a...11n).

8. ADC device comprising at least one continuous-time analog-to-digital converter circuit (100) according to the preceding claims.

9. ADC device according to claim 8, wherein the delays of the circuits (100) are calibrated sequentially in a specified order, wherein the outputs of each single circuit (100) are used.

10. Method for calibrating a continuous-time analog-to-digital converter circuit (100), comprising the steps:
- applying an analog input signal (vᵢₙ) to an input (1);
- sampling the analog input signal (vᵢₙ) with a specified sampling rate (fs);
- digitizing the sampled analog input signal (vᵢₙ) and reconverting the digitized analog input signal (vᵢₙ) back to analog and subtract the reconverted signal at a first summation node (20a; 20b);
- filtering an output (r) at the first summation node (20a; 20b) by an analog filter element (30a; 30b) and sampling of an output of the analog filter element (30a; 30b) by the specified sampling rate (fs);
- digitizing the sampled output of the analog filter element (30a; 30b); and
- matching the delay of an ADC-DAC path of the continuous-time analog-to-digital converter circuit (100) to the delay (td) of the analog delay element (10a...10n), wherein an output of the analog filter element (30a; 30b) is sampled by the specified sampling rate (fs), wherein the sampled output of the analog filter element (30a; 30b) is digitized by a backend ADC (41) connected to a second summation node (42), wherein the delay of the ADC-DAC path is controlled by means of a coarse delay control and a fine delay control, wherein the coarse delay control comprises delay elements (13a, 13b) to be switched in a connection path between a sub ADC (11a...11n) and a sub DAC (12a...12n) and wherein the fine delay control controls a clock signal (clk_{dac}) of the sub DAC (12a...12n).

11. Method according to claim 10, wherein at first the coarse delay is set to come as close as possible to the delay of the analog delay element (10a...10n).

12. Method according to claim 11, wherein once the coarse delay is determined, a fine tuning is done by controlling the clock signal (clk_{dac}) of the sub-DAC (12a...12n) of the ADC-DAC path.

13. Method according to any of the claims 10 to 12, wherein data with respect to the matching procedure is stored.
